(19) Europäisches Patentamt / European Patent Office / Office européen des brevets

(11) **EP 4 481 330 B1**

(12) **EUROPÄISCHE PATENTSCHRIFT**

(45) Veröffentlichungstag und Bekanntmachung des Hinweises auf die Patenterteilung:
**28.01.2026   Patentblatt 2026/05**

(21) Anmeldenummer: **24180241.2**

(22) Anmeldetag: **05.06.2024**

(51) Internationale Patentklassifikation (IPC):
**G01D 5/14** *(2006.01)*      **G01D 3/036** *(2006.01)*

(52) Gemeinsame Patentklassifikation (CPC):
**G01D 5/145; G01D 3/036**

(54) **VERFAHREN ZUR MESSUNG EINER POSITION EINES MAGNETEN DURCH EINE SENSOR-ANORDNUNG MIT EINER ERHÖHTEN MAGNETISCHEN FREMDFELD-ROBUSTHEIT UNTER BERÜCKSICHTIGUNG DES SIGNAL-RAUSCH-VERHÄLTNISSES**

METHOD FOR MEASURING A POSITION OF A MAGNET BY A SENSOR ASSEMBLY HAVING AN INCREASED MAGNETIC ALIEN FIELD ROBUSTNESS TAKING INTO ACCOUNT THE SIGNAL-TO-NOISE RATIO

PROCÉDÉ DE MESURE D'UNE POSITION D'UN AIMANT PAR UN AGENCEMENT DE CAPTEUR AVEC UNE ROBUSTESSE DE CHAMP MAGNÉTIQUE ÉTRANGER ACCRUE EN TENANT COMPTE DU RAPPORT SIGNAL-BRUIT

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **21.06.2023   DE 102023116302**

(43) Veröffentlichungstag der Anmeldung:
**25.12.2024   Patentblatt 2024/52**

(73) Patentinhaber: **elobau GmbH & Co. KG**
**88299 Leutkirch im Allgäu (DE)**

(72) Erfinder:
- **Butscher, Roland**
  **88316 Isny (DE)**
- **Gerhardt, Ulrich**
  **88299 Leutkirch (DE)**

(74) Vertreter: **VKK Patentanwälte PartG mbB**
**Edisonstraße 2**
**87437 Kempten (DE)**

(56) Entgegenhaltungen:
EP-B1- 2 616 778          DE-A1- 102018 123 885
DE-A1- 102018 129 487

**Beschreibung**

Die vorliegende Erfindung betrifft ein Verfahren zur Messung einer Position eines Magneten durch eine Sensor-Anordnung mit einer erhöhten magnetischen Fremdfeld-Robustheit unter Berücksichtigung des Signal-Rausch-Verhältnisses.

**In** vielen verschiedenen Anwendungen ist es erforderlich, die Position eines Bedienelements oder eines Sensors im Raum zu bestimmen und dadurch dessen Bedienzustand zu ermitteln. Dadurch lassen sich zahlreiche voneinander unterscheidbare Bedienpositionen einrichten, ohne dass etwaige mechanische Rastpositionen oder ähnliches dafür notwendig sind. Ebenso hat dies den Vorteil, dass je nach aktueller Position des Bedienelements unterschiedliches Feedback an einen Benutzer weitergegeben wird und dieser darauf entsprechend reagieren kann.

Üblicherweise erfolgt diese Positionsbestimmung über eine Anordnung enthaltend einen Magneten, insbesondere eines Permanent- oder Elektromagneten, welcher in der Regel an dem Bedienelement angeordnet ist, und mindestens einem Sensor, welcher das Magnetfeld aufgeschlüsselt in den relevanten Raumdimensionen bestimmen kann. Das gemessene Magnetfeld wird üblicherweise mit dem Magnetfeld des am Bedienelement befindlichen Magneten zumindest in einer Nullposition des Bedienelements oder aber mit einer Messung unter Laborbedingungen abgeglichen, um die Positionsänderung des Magneten gegenüber einer Nullposition zu ermitteln. Dabei ist diese Bestimmung der Position des Magneten in zwei wesentlichen Punkten fehleranfällig: zum einen wird die Messung durch ein Rauschen des Signals verfälscht, welches inhärent durch die Bauteile der Anordnung in das System eingebracht werden. Zum anderen kann das Magnetfeld des Magneten am Bedienelement durch ein Fremdfeld überlagert werden, wodurch ebenfalls die Messergebnisse der Magnetflussdichten verfremdet werden und sich von einer Messung unter Labor- beziehungsweise idealen Bedingungen unter Umständen signifikant unterscheiden, was zu einer fehlerhaften Positionsbestimmung führt.

So ist es im Stand der Technik bekannt, mehr als einen Sensor zu verwenden, sodass die Messung eines der Sensoren durch einen weiteren an einer anderen Position verifiziert werden kann. Zudem ist es bekannt, die Differenzen der durch die Mehrzahl an Sensoren gemessenen Magnetflussdichten zur Ermittlung der Position des Magneten zu verwenden, sodass ein Fremdfeld, welches auf beide Sensoren idealerweise gleichermaßen wirkt, durch die Differenzbildung herausgerechnet wird und das berechnete Signal entsprechend eine Fremdfeldimmunität aufweist.

Demnach ist aus dem Stand der Technik EP 1 464 918 B1 ein Verfahren zur Messung der Position eines Magneten relativ zu einem Messort bekannt, bei dem durch zwei Magnetfeldsensoren jeweils das Magnetfeld gemessen wird und die Position des Magnets im Raum durch eine Differenzquotientenbildung aus diesen gemessenen Magnetfeldern ermittelt wird. Zwar hat diese Methode den Vorteil, dass die ermittelte Position des Magnets fremdfeldbereinigt ist, jedoch sind die aus der Bildung von Differenzquotienten ermittelten Signale deutlich abgeschwächt und ein Rauschen relativ zum Signal deutlich verstärkt.

DE 10 2018 129487 A1 zeigt ein weiteres bekanntes Verfahren zur Messung der Position eines Magneten.

Demgegenüber ist ein absolut gemessenes Signal, welches nicht durch Differenzbildung mit durch andere Sensoren gemessene Signale verrechnet wird, ein besonders starkes Signal, bei dem ein Rauschen aufgrund der bauteilbedingten Toleranzen weniger stark ins Gewicht fällt. Jedoch ist in diesem absolut gemessenen und nicht verrechneten Signal das Fremdfeld unverändert und in voller Höhe enthalten, sodass dieses Signal trotz gutem Signal-Rausch-Verhältnis unter Umständen stark verfälscht ist.

Folglich liegt der Erfindung die Aufgabe zu Grunde, ein Verfahren zur Ermittlung der Position eines Magneten vorzuschlagen, bei dem das ermittelte Ergebnis sowohl eine Fremdfeldrobustheit als auch ein vorteilhaftes Signal-Rausch-Verhältnis aufweist.

Diese Aufgabe wird gelöst durch ein Verfahren zur Signalverarbeitung aus einer Magnet-Sensor-Anordnung, wobei die Magnet-Sensor-Anordnung mindestens ein Sensorpaar und einen dazu bewegbar gelagerten Magneten umfasst, aufweisend die folgenden Schritte:

a) Messung der Magnetflussdichte je Raumkoordinate je Sensor

b) Nicht-Differentielles Berechnen einer Positionsänderung des Magneten je in Schritt a) gemessener Magnetflussdichte

c) Berechnen der Differenzen der gemessenen Magnetflussdichten je Raumkoordinate

d) Differentielles Berechnen einer Positionsänderung des Magneten aus den in Schritt c) berechneten Magnetflussdichten

e) Normieren der nicht-differentiell und differentiell berechneten Positionsänderungen des Magneten auf Basis einer Nullposition des Magneten

f) Berechnen der Differenzen der differentiell berechneten Positionsänderung des Magneten und den nicht-differentiell berechneten Positionsänderungen des Magneten

g) Berechnen eines Gewichtungsfaktors aufgrund der in Schritt f) berechneten Differenzen

h) Berechnen eines durch den Gewichtungsfaktor aus Schritt g) gewichteten Mittelwerts der in Schritt e) normierten nicht-differentiell und differentiell berechneten Positionsänderungen des Magneten um eine bereinigte Positionsänderung zu erhalten.

Die den Messungen nach Schritt a) des Verfahrens zugrundeliegende Magnet-Sensor-Anordnung besteht dabei aus mindestens einem Sensorpaar und einen dazu bewegbar gelagerten Magneten. Unter einem Magneten versteht die Erfindung jegliche Vorrichtung, von der ein Magnetfeld ausgeht, also insbesondere Dauer- oder Elektromagnete. Die Beweglichkeit des Magneten ist dabei vor allem eine zu dem mindestens einen Sensorpaar relative Beweglichkeit, sodass eine Positionsänderung des Magneten relativ zu einer Position des Sensorpaars durch das Sensorpaar wahrnehmbar beziehungsweise messbar ist. Dabei ist je Richtung entlang einer Raumkoordinate, in der der Magnet relativ zum Sensorpaar beweglich ist und die Position des Magneten zu bestimmen ist, ein Sensorpaar vorteilhaft. So ist es bei einer linearen Bewegung in eine Richtung oder aber auch bei einer Schwenkbewegung um eine Schwenkachse erforderlich, nur ein Sensorpaar zu verwenden. Ist jedoch eine Bewegung in einer Ebene oder um zwei Schwenkachsen zu bestimmen, sind je Bewegungsachse ein Sensorpaar, in diesem Fall also zwei Sensorpaare erforderlich. Entsprechend ist jedes Sensorpaar für die Bestimmung der Positionsänderung in einer zugehörigen Bewegungsrichtung zuständig. Dabei ist es insbesondere bei Schwenkbewegungen des Magneten von Vorteil, wenn die Sensoren Hall-Sensoren, besonders bevorzugt 3D-Hall-Sensoren, oder andere 3D-Sensoren sind, um die Schwenkbewegung des Magneten und entsprechend die davon ausgehende Magnetflussdichte in einem kartesischen Koordinatensystem abzubilden. Alternativ ist auch die Anwendung von Sensoren in Form von XMR-Sensoren, beispielsweise als TMR-, AMR- oder GMR-Sensoren erfindungsgemäß.

Im ersten Schritt a) des Verfahrens wird die Magnetflussdichte in den relevanten Raumrichtungen eines kartesischen Koordinatensystems je Sensor gemessen, sodass daraus im Fall von 3D-Sensoren die Magnetflussdichten in allen drei Raumrichtungen eines kartesischen Koordinatensystems je Sensor gemessen werden. Demnach erhält man im Beispiel der 3D-Sensoren die Magnetflussdichten nach dem Prinzip $B_{xi}$, $B_{yi}$ und $B_{zi}$, wobei $x$, $y$ und $z$ die kartesischen Koordinaten wiedergeben und $i$ der Index des jeweiligen 3D-Sensors ist. Diese gemessenen Magnetflussdichten sind Rohdaten, welche jegliche Fremdfeldeinflüsse und auch die Position der Sensoren relativ zu einem Nullpunkt des Magneten unverfälscht beinhalten. Aus diesen Rohdaten werden in Schritt b) je Sensor eine Position oder eine Positionsänderung relativ zu einer Nullposition des Magneten berechnet. Daraus ergibt sich eine Position oder Positionsänderung, die aufgrund der genannten äußeren Einflüsse in aller Regel nicht der tatsächlichen Größe entspricht und demnach entsprechend keine Fremdfeldimmunität aufweist. Als Position oder Positionsänderung, oder aber auch Distanz versteht die Erfindung die Lage, in der sich der Magnet im Raum befindet, wobei die Nullposition des Magneten als Ausgangspunkt oder Nullpunkt eines Koordinatensystems definiert ist, in dem die Position festgestellt wird. Demnach werden die Bezeichnungen Position und Positionsänderung im Zusammenhang mit dieser Erfindung austauschbar verwendet.

Zur Berechnung einer Position mit Fremdfeldimmunität werden die Differenzen der Magnetflussdichten berechnet, wobei jeweils die Differenz der durch die beiden Sensoren eines Sensorpaars gemessenen Magnetflussdichten je relevanter Raumrichtung berechnet wird. Aufgrund der Berechnung der Differenz zweier durch das gleiche Fremdfeld beeinflussten Magnetflussdichten, wird dieses Fremdfeld aus dem Ergebnis entfernt, sofern die Sensoren hinreichend nahe beieinander liegen, sodass das Fremdfeld im Bereich der Sensoren nahezu homogen erscheint, oder das Fremdfeld nahezu homogen ist, sodass das Ergebnis der Berechnung eine fremdfeldbereinigte Magnetflussdichte ist. Aus diesen fremdfeldbereinigten Magnetflussdichten wird wie auch schon in Schritt b) eine Position des Magneten ermittelt. Diese Differenzen der Magnetflussdichten und die daraus berechnete Position des Magneten haben zwar eine Fremdfeldimmunität, jedoch sind die Differenzen der gemessenen Magnetflussdichten deutlich anfälliger gegenüber einem Signalrauschen aufgrund technischer Toleranzen der Sensoren, sodass die Präzision der Messungen und der daraus berechneten Positionen gegenüber den Werten aus den Verfahrensschritten a) und b) verringert ist. Die genannten Differenzen, die in den Schritten c) und d) berechnet werden, sind dabei die Differenzen der gemessenen Werte eines Sensorpaars. Wird das Verfahren für mehrere Sensorpaare durchgeführt, beispielsweise da die Position des Magneten in mehreren Raumrichtungen bestimmt werden soll, werden die Differenzen der Schritte c) und d) pro Raumrichtung und entsprechend der Raumrichtung zugeordnetem Sensorpaar berechnet.

So werden in den Schritten c) und d) die Daten zwar weitestgehend vom Fremdfeld bereinigt, jedoch sind diese Daten aufgrund der zu einem Nullpunkt des Magneten versetzten Position der Sensoren weiterhin verfälscht und geben nicht die tatsächliche Position des Magneten im Raum wieder. Daher werden die in den Schritten b) und d) berechneten Positionen anhand der Position der Sensoren relativ zur Nullposition des Magneten in einem Schritt e) normiert, wobei die Normierung erfindungsgemäß eine Skalierung und/oder eine Offset-Korrektur umfasst.

Dies erfolgt besonders vorteilhaft relativ zu einem Äquidistanzpunkt zwischen den beiden Sensoren des betroffenen Sensorpaars, welcher insbesondere direkt unter einer Nullposition des Magneten angeordnet ist. Dadurch ist eine Vergleichbarkeit der durch die beiden Sensoren gemessenen Magnetflussdichten und eine entsprechend einfachere Berechnung der Position des Magneten ermöglicht.

In dem weiteren Schritt f) werden die Differenzen der Positionen berechnet, welche aus den unterschiedlichen Berechnungsmethoden aus den Schritten b) und d) erhalten wurden und anschließend in Schritt e) normiert wurden. Aus diesen Ergebnissen lassen sich im Übrigen Rückschlüsse über das Fremdfeld ziehen, welches in der Position aus Schritt b) zwar vorhanden, in der aus Schritt d) jedoch bereits herausgerechnet wurde. Die Differenz der Positionen wird in Schritt f) für jeden Sensor berechnet, wobei die in Schritt b) berechneten Positionen jeweils von der in Schritt d) differentiell berechneten Position subtrahiert werden.

Diese Differenzen der Positionen aus den unterschiedlichen Berechnungsmethoden sind in der Berechnung des Gewichtungsfaktors in Schritt g) zu beachten, welcher insbesondere einen Wert zwischen 0 und 1 annimmt. Aufgrund der Größe der Differenz ist eine entsprechend große Auswirkung des Fremdfelds auf das Messergebnis der Sensoren feststellbar. So ist es von Vorteil, wenn für die Positionsbestimmung möglichst wenig Fremdfeldeinflüsse in die Berechnung einfließen, gleichzeitig jedoch ein möglichst gutes Signal-Rausch-Verhältnis der Faktoren der Berechnung gegeben ist. Demnach spielt der Gewichtungsfaktor eine umso größere Rolle, je stärker das Fremdfeld ist.

Mit diesem Gewichtungsfaktor wird ein gewichteter Mittelwert der normierten nicht-differentiell berechneten Positionsänderungen aus Schritt b) und differentiell berechneten Positionsänderungen aus Schritt d) gebildet um daraus eine Position des Magneten zu erhalten, die sowohl von einem Fremdfeld als auch von einem verschlechterten Signal-Rausch-Verhältnis jeweils möglichst gering beeinflusst ist.

In Weiterbildung der Erfindung wird vorgeschlagen, dass der bewegbare Magnet um mindestens eine Schwenkachse schwenkbar gelagert ist und die Positionsänderung in Form eines Auslenkwinkels gemessen wird. So findet das Verfahren in einem System mit einem schwenkbaren Hebel, an dem ein Magnet angeordnet wird, Anwendung. Dies ist regelmäßig bei Steuerungshebeln oder ähnlichem notwendig, bei denen aufgrund der Position des Hebels bestimmte Funktionen auszuführen oder bestimmtes Feedback an den Nutzer zu geben ist.

In Ausgestaltung der Erfindung wird vorgeschlagen, dass der Auslenkwinkel über eine trigonometrische Funktion aus den gemessenen Magnetflussdichten berechnet wird. Aufgrund der Schwenkbewegung eines Hebels, an dem der Magnet angeordnet ist, ist der Magnet auf einer Kreisbahn beweglich. Diese Kreisbahn des Magneten ermöglicht die Berechnung des Auslenkwinkels über trigonometrische Funktionen, da die gemessene Magnetflussdichte des Magneten in einer Schwenkbewegung in Abhängigkeit vom Auslenkwinkel im Wesentlichen den Verlauf einer Sinus- bzw. Kosinuskurve zeigt. Da diese Kurve erwartungsgemäß aufgrund der Position der Sensoren relativ zu einer Nullposition des Magneten zu einem Auslenkwinkel von 0° verschoben ist, sind die aus der trigonometrischen Funktion berechneten Auslenkwinkel entsprechend in einem Verfahrensschritt e) zu normieren.

In Weiterbildung der Erfindung wird vorgeschlagen, dass der differentiell berechnete Auslenkwinkel über eine trigonometrische Funktion aus den Differenzen der gemessenen Magnetflussdichten berechnet wird. Wie auch zur nicht-differentiellen Berechnung des Auslenkwinkels ist die Berechnung hier über eine trigonometrische Funktion aufgrund der Schwenkbewegung des Magneten ermöglicht.

Sowohl in der differentiellen, als auch in der nicht-differentiellen Berechnung des Auslenkwinkels ist die Verwendung einer Arcussinus- oder Arcuskosinusfunktion denkbar, jedoch ist bei der Berechnung darauf zu achten, dass das Ergebnis ein eineindeutiger Winkel ist. Dies ist vor allem dann unsicher, wenn die berechneten Winkel an die $\pm90°$-Grenze kommen, was aufgrund der Verschiebung der Sensoren zu einem Nullpunkt bereits bei deutlich geringeren, tatsächlichen Auslenkwinkeln des Magneten möglich ist. Daher ist es vorteilhaft, wenn dafür eine Arcustangens-Funktion, insbesondere eine Arcustangens2-Funktion verwendet wird, welche ein eineindeutiges Ergebnis ausgibt. Dabei ist es sinnvoll, wenn möglich, entweder den differentiell oder die nicht-differentiell berechneten Auslenkwinkel durch eine Sinus- oder Kosinusfunktion zu berechnen und den jeweils anderen Auslenkwinkel durch die Arcustangens2-Funktion, da der Verlauf der differentiell und nicht-differentiell berechneten Magnetflussdichten in Abhängigkeit des Auslenkwinkels zwar im Wesentlichen, jedoch nicht exakt einer Sinus- bzw. Kosinuskurve entspricht. So können die Berechnungsmethoden dadurch diversifiziert werden und in der Verarbeitung dieser berechneten Auslenkwinkel durch einen Mehrpunkt-Abgleich oder eine Linearisierung etwaige Abweichungen von einer idealen Sinus- bzw. Kosinuskurve ausgeglichen werden.

In Ausgestaltung der Erfindung wird vorgeschlagen, dass der gewichtete Mittelwert jeweils aus einer der nicht-differentiell berechneten Positionsänderungen und der differentiell berechneten Positionsänderung gebildet wird, wobei die gesamt berechnete Positionsänderung über den Mittelwert der gewichteten Mittelwerte berechnet wird. Dabei werden insbesondere die Summen der gewichteten normierten differentiell berechneten Position und gewichteten normierten nicht-differentiell berechneten Positionen gebildet und miteinander zu einem Gesamtergebnis verrechnet. Die Gewichtung hat dabei zur Folge, dass bei einem starken Fremdfeld und einem entsprechenden Gewichtungsfaktor die fremdfeldimmune differentiell berechnete Position aus Schritt d) stärker ins Gewicht fällt als die fremdfeldanfällige nicht-differentiell berechnete Position, sodass das Fremdfeld weitestgehend herausgerechnet und das schlechtere Signal-Rausch-Verhältnis hingenommen wird. Ist das Fremdfeld jedoch schwach oder gar nicht vorhanden, ist die fremdfeldimmune differentiell berechnete Position entsprechend weniger gewichtet als die nicht-differentiell berechnete Position, sodass das Signal-Rausch-Verhältnis verbessert ist.

In Weiterbildung der Erfindung wird vorgeschlagen, dass die Normierung nach Schritt e) über einen Mehrpunkt-Abgleich, insbesondere einen 9-Punkt-Abgleich oder 15-Punkt-Abgleich erfolgt. Unter einem Mehrpunkt-Abgleich versteht die Erfindung eine Fixierung der Position an mehreren Punkten, sodass die in Schritt b) oder d) berechnete Position an mehreren Punkten, bei einem 9-Punkt-Abgleich beispielsweise an neun Punkten, mit der erwarteten Positionen gleichgesetzt werden. Die übrigen Werte, welche nicht mit den Punkten gleichgesetzt werden, werden anhand einer Abweichung des idealen Wertes von dem berechneten Wert wie auch in dem erfindungsgemäßen Schritt e) normiert. Dadurch erfolgt die Normierung insgesamt deutlich feingliedriger als eine einfache Normierung und ermöglicht eine deutlich präzisere Ermittlung der Position des Magneten.

In Ausgestaltung der Erfindung wird vorgeschlagen, dass ein die Messungen beeinflussendes magnetisches Fremdfeld durch aus der Differenz der beiden unterschiedlich berechneten Positionsänderungen ermittelt wird, wobei diese Positionsänderungen durch den Mehrpunktabgleich korrigiert werden. Wie zuvor bereits ausgeführt, wird das Fremdfeld erfindungsgemäß durch die Abweichungen der Ergebnisse aus den unterschiedlichen Berechnungsmethoden ermittelt. Unter der Ergänzung dieser Ermittlung des Fremdfeldes durch den Mehrpunktabgleich versteht die Erfindung eine Anwendung des Mehrpunktabgleichs auf die Ergebnisse aus den unterschiedlichen Berechnungsmethoden. Die unter Anwendung des Mehrpunktabgleichs erhaltenen Daten entsprechen nahezu der jeweils tatsächlichen Position des Magneten, sodass eine Abweichung der aus den Messwerten berechneten Position von diesen Daten Rückschlüsse auf Verfälschungen der erwarteten Position zulässt, welche zumindest überwiegend aufgrund eines Fremdfeldes entstehen. So werden durch den Mehrpunktabgleich insbesondere Einflüsse potentieller Nichtlinearitäten, Steigungs- oder Offsetfehler der unterschiedlichen Berechnungsmethoden der Positionsänderung minimiert. Demnach entsprechen diese Abweichungen der Positionen, welche in eine Magnetflussdichte zurückgerechnet werden müssen, dem Fremdfeld.

In Weiterbildung der Erfindung wird vorgeschlagen, dass ein die Messungen beeinflussendes magnetisches Fremdfeld aus der Differenz der beiden unterschiedlich berechneten Positionsänderungen ermittelt wird, wobei diese Positionsänderungen durch einen Abgleich mit einer Messung unter Laborbedingungen korrigiert werden. Es gilt das gleiche wie zur Korrektur durch den Mehrpunktabgleich, wobei hier die berechneten Ergebnisse ebenfalls von einem mathematischen Fehler bereinigt werden. Ein solcher Fehler wurde zuvor bereits im Falle einer Schwenkbewegung des Magneten beschrieben, bei der die gemessene Magnetflussdichte in Abhängigkeit des Auslenkwinkels im Wesentlichen, jedoch nicht exakt, einer Sinus- bzw. Kosinuskurve entspricht und somit die Verwendung einer Arcussinus- oder Arcuskosinusfunktion zur Berechnung des Auslenkwinkels einen, wenn auch geringen, mathematischen Fehler aufweist.

**In** Ausgestaltung der Erfindung wird vorgeschlagen, dass bei der Berechnung des Gewichtungsfaktors eine vordefinierbare Konstante $A_{max}$ berücksichtigt wird, welche den Grad der Abweichung zwischen differentiell und nicht-differentiell berechneter Positionsänderung beschreibt, ab dem für die Berechnung der Positionsänderung das Signal ausschließlich aus der differentiell berechneten Positionsänderung nach Schritt d) verwendet wird. Diese Konstante ist vordefinierbar, sodass diese für unterschiedliche Applikationen, vor allem in Abhängigkeit der Stärke eines Fremdfeldes veränderbar ist, nicht jedoch sich aufgrund etwaiger Messergebnisse dynamisch verändert. Durch geeignete Wahl der Konstante sind die Grenzen zwischen einem verrauschten und einem fremdfeldunabhängigeren Signal abstimmbar. So ist es vorteilhaft, wenn die Konstante bei einem starken Fremdfeld derart gewählt wird, dass der Gewichtungsfaktor entsprechend zugunsten der fremdfeldimmunen, differentiell berechneten Position ausfällt und die nicht-differentiell berechneten Position entsprechend gering gewichtet. Dies lässt sich insbesondere durch folgende mathematische Abhängigkeit bewerkstelligen:

$$W_i \sim \frac{|\Delta\alpha_i|}{A_{max}}$$

Wobei W für den Gewichtungsfaktor, der Index i für einen der Sensoren und $\Delta\alpha$ für die in Schritt f) berechnete Differenz steht.

In Weiterbildung der Erfindung wird vorgeschlagen, dass bei der Berechnung des Gewichtungsfaktors eine vordefinierbare Konstante $O_{diff}$ berücksichtigt wird, durch die vorgegeben werden kann, wie viel Prozent der des differentiell berechneten Signals für die Berechnung der Positionsveränderung zu verwenden ist. Unter der Konstante $O_{diff}$ versteht die Erfindung insbesondere einen Offset, welcher auf die normierte bzw. skalierte Differenz aus Schritt f) addiert oder subtrahiert wird. Sind demnach beispielsweise schwächere magnetische Fremdfelder vorhanden, die zu kleinen aber in einer erlaubten Toleranz liegenden Änderungen der Messwerte führen, so kann mittels dieser Konstante eine übermäßige Gewichtung der differentiell berechneten Position unterdrückt werden, sodass weiterhin die nicht-differentiell berechneten Position mit einem guten Signal-Rausch-Verhältnis verwendet werden kann. Dies ist vor allem dann von Vorteil, wenn das Rauschen im differentiell berechneten Signal größer wäre als ein Fremdfeldeinfluss auf das rauscharme nicht-differentiell berechnete Signal. Dabei ist diese Konstante genauso wie die oben beschriebene Konstante $A_{max}$ vordefinierbar und bei Bedarf für unterschiedliche Applikationen anpassbar.

In beispielhaften Ausführungsformen der Erfindung, welche insbesondere bei relativen Schwenkbewegungen zwischen Sensorpaar und Magnet vorteilhaft sind, können folgende Formeln für die in den Schritten b), d), e), f), g) und h) vorgesehenen Berechnungen angewendet werden, wobei die jeweiligen Formeln unabhängig voneinander in verschiedenen Ausführungsformen oder gemeinsam in einer einzigen Ausführungsform anwendbar sind.

Schritt b) sieht die nicht-differentielle Berechnung der Positionsänderung vor. Diese kann über einfache trigonometrische Formeln nach folgendem Prinzip erfolgen:

$$\alpha_i = \sin^{-1}\left(\frac{B_{x,i}}{|B_i|}\right)$$

Wobei $\alpha$ für die berechnete Positionsänderung, der Index i für einen der Sensoren und $B_x$ für die gemessene Magnetflussdichte in x-Richtung, also entlang der Schwenkrichtung, steht.

Schritt d) sieht die differentielle Berechnung der Positionsänderung vor. Diese kann ebenfalls über einfache trigonometrische Formeln nach folgendem Prinzip erfolgen:

$$d\alpha = atan2(-dB_x, dB_z)$$

Wobei $d\alpha$ für die berechnete Positionsänderung, $dB_x$ für die in Schritt c) berechnete differentielle Magnetflussdichte in x-Richtung, also entlang der Schwenkrichtung, und $dB_z$ für die in Schritt c) berechnete differentielle Magnetflussdichte in z-Richtung, also in Nullposition des Systems radial zur Schwenkbewegung, steht.

Schritt e) sieht die Normierung der nicht-differentiell und differentiell berechneten Positionsänderung vor. Diese kann vorzugsweise mit Hilfe einer einfachen Kalibrierung über die beiden Maximalauslenkungen, oder aber mit Hilfe einer Mehrpunktkalibrierung, beispielsweise unter Verwendung einer der folgenden Formeln erfolgen.

Für eine Mehrpunktkalibrierung sind erfindungsgemäß folgende Formeln vorteilhaft:

$$\alpha_{i,\,norm} = \left[(\alpha_i - \alpha_{i,calc,\,1}) * \left(\frac{(\alpha_{i,set,\,2} - \alpha_{i,set,\,1})}{(\alpha_{i,calc,\,2} - \alpha_{i,calc,\,1})}\right)\right] + \alpha_{i,set,1}$$

für die nicht-differentielle Berechnung und

$$d\alpha_{i,norm} = \left[(d\alpha_i - d\alpha_{i,calc,\,1}) * \left(\frac{(d\alpha_{i,set,\,2} - d\alpha_{i,set,\,1})}{(\alpha_{i,calc,\,2} - \alpha_{i,calc,\,1})}\right)\right] + \alpha_{i,set,1}$$

für die differentielle Berechnung.

Wobei $\alpha_{i,\,norm}$ bzw. $d\alpha_{i,norm}$ für die berechnete Positionsänderung, der Index i für einen der Sensoren, der Index 1 für einen ersten Kalibrierpunkt und der Index 2 für einen zweiten Kalibrierpunkt der Mehrpunktkalibrierung, $\alpha_{i,calc}$ bzw. $d\alpha_{i,calc}$ für die berechnete Position an einem Kalibrierpunkt, also entlang der Schwenkrichtung, und $\alpha_{i,set}$ bzw. $d\alpha_{i,set}$ für den Winkel eines Kalibrierpunkts steht.

Schritt f) sieht die Berechnung der Differenzen der differentiell berechneten Positionsänderung und den nicht-differentiell berechneten Positionsänderungen vor. Darunter versteht die Erfindung eine Berechnung nach folgender Formel:

$$\Delta\alpha_i = d\alpha - \alpha_i$$

Schritt g) verwendet die in Schritt f) berechneten Differenzen zur Berechnung eines Gewichtungsfaktors zur Gewichtung der Messwerte je nach Auswirkung des Fremdfelds auf das Messergebnis, sodass die differentiell berechnete, fremdfeldimmune Position bei stärkerem Fremdfeldeinfluss stärker gewichtet wird. Zur Berechnung eines Gewichtungsfaktors ist erfindungsgemäß die Verwendung folgender Formel besonders vorteilhaft:

$$W_i = \frac{|\Delta\alpha_i|}{A_{max}} + O_{diff}$$

wobei wenn $W_i < 0$, dann $W_i = 0$
und wenn $W_i > 1$, dann $W_i = 1$

Wobei W für den Gewichtungsfaktor, der Index i für einen der Sensoren, $\Delta\alpha_i$ für die in Schritt f) berechnete Differenz steht. Die vordefinierbaren Konstanten $A_{max}$ und $O_{diff}$ sind von einem Benutzer frei wählbar und erlauben es dem Benutzer, den Fremdfeldeinfluss nach eigenem Ermessen in der Berechnung zu berücksichtigen.

Schritt h) sieht die Berechnung einer bereinigten Positionsänderung unter Zuhilfenahme des gewichteten Mittelwerts aus Schritt g) vor. Dies erfolgt erfindungsgemäß besonders vorteilhaft über folgende Formel:

$$P_i = W_i * d\alpha_{norm} - (1 - W_i) * \alpha_{i,norm}$$

und deren anschließende Mittelwertbildung:

$$P = \frac{P_1 + P_2}{2}$$

Wobei $P_i$ für die gewichtete Positionsänderung ermittelt am Sensor i und P für den gewichteten Mittelwert der Positionsänderungen steht.

Die Erfindung wird nachfolgend anhand von Figuren einer Zeichnung näher erläutert. Baugleiche Teile werden dabei mit demselben Bezugszeichen versehen.

Fig. 1:    schematischer Verlauf des Verfahrens

Fig. 2:    Magnet-Sensor-Anordnung in einer bevorzugten Ausführungsform

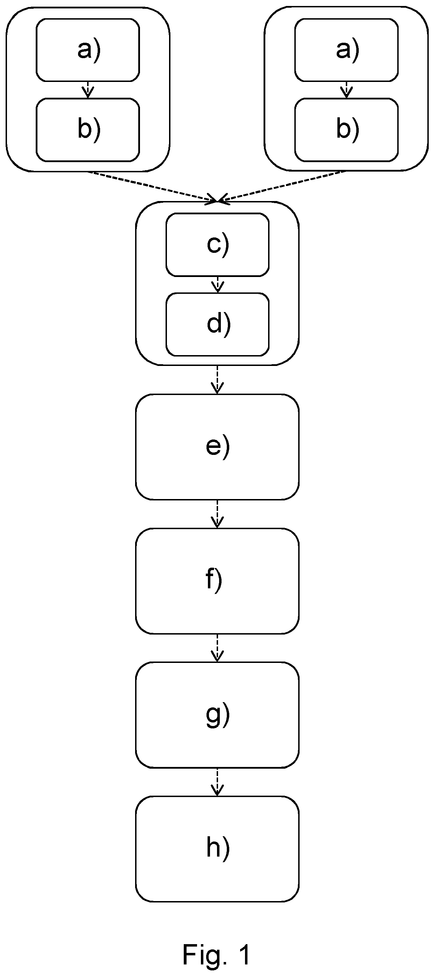

**Fig. 1** zeigt den schematischen Verlauf des erfindungsgemäßen Verfahrens. Der dargestellte schematische Verlauf betrifft dabei ein erfindungsgemäßes Verfahren, bei dem die Signale eines Magneten 2 von zwei Sensoren 3a, 3b, beziehungsweise einem Sensorpaar 3 gemessen und verarbeitet werden. Die ersten beiden Verfahrensschritte a) und b) erfolgen jeweils je Sensor 3a, 3b. So wird im ersten Verfahrensschritt a) die vom Magneten 2 ausgehende Magnetflussdichte je Raumkoordinate erfasst. Die Anzahl der Raumkoordinaten ist jedoch von der Beweglichkeit des Magneten 2 relativ zum Sensor 3a, 3b abhängig, sodass die Magnetflussdichte nicht zwangsweise in alle drei Raumkoordinaten bestimmt werden muss. Weiter wird in dem Verfahrensschritt b) eine nicht-differentiell berechnete Positionsänderung der Positionsänderung des Magneten 2 je in Schritt a) gemessener Magnetflussdichte berechnet. Das nicht-Differentielle bezieht sich dabei auf die Berechnung der Positionsänderung aus den Absolutwerten der gemessenen Magnetflussdichte. Die Distanz der Positionsänderung ist erfindungsgemäß eine Distanz oder Position, wobei diese Bezeichnungen nachfolgend weiterhin austauschbar verwendet werden, relativ zu einer Nullposition des Magneten 2. Die nachfolgenden Schritte c) und d) entsprechen im Wesentlichen den Verfahrensschritten a) und b), wobei diese ein einziges Mal und insbesondere nicht je Sensor ausgeführt werden. So werden in Schritt c) die Differenzen der in Schritt a) gemessenen Magnetflussdichten je Raumkoordinate berechnet. Das Ergebnis ist demnach im Gegensatz zu den Absolutwerten aus Schritt a) eine differentiell berechnete Magnetflussdichte, welche in Schritt d) analog zu Schritt b) zur differentiellen Berechnung einer Positionsänderung des Magneten 2 herangezogen werden. Im anschließenden Verfahrensschritt e) werden sowohl die nicht-differentiell berechneten, als auch die differentiell berechneten Positionen des Magneten 2 aus den Verfahrensschritten b) und d) auf Basis einer Nullposition des Magneten 2 normiert. Diese Normierung ist erforderlich, da die in Schritt a) gemessenen Magnetflussdichten durch Sensoren 3a, 3b ermittelt wurden, welche sich an Positionen befinden, die von einer Nullposition des Magneten 2 beabstandet sind, die Position des Magneten 2 jedoch relativ zu dieser Nullposition bestimmt werden soll. Entsprechend fließt dieser Fehler in die aus den gemessenen Magnetflussdichten in Schritt c) berechneten Magnetflussdichten und in die in den Schritten b) und d) daraus berechneten Positionen des Magneten 2 ein, sodass diese Werte ebenfalls zu normieren sind. Anschließend werden im Verfahrensschritt f) die Differenzen der differentiell berechneten Position und der nicht-differentiell berechneten Positionen des Magneten 2 berechnet. Demnach ergibt sich je nicht-differentiell berechneter Position eine Differenz jeweils zur differentiell berechneten Position des Magneten 2. Durch diese Differenzen lassen sich zum einen Rückschlüsse auf ein Fremdfeld ziehen, da die nicht-differentiell berechnete Position den FremdfeldEinfluss beinhaltet, während die differentiell berechnete Position fremdfeldimmun ist. Zudem sind diese Differenzen in dem weiteren Verfahrensschritt g) zu beachten, in dem aus diesen Differenzen ein Gewichtungsfaktor berechnet wird. So ist aufgrund der Größe der Differenz eine entsprechend große Auswirkung des Fremdfelds auf das Messergebnis der Sensoren feststellbar und der Gewichtungsfaktor entsprechend derart ausfällt, dass die differentiell berechnete, fremdfeldimmune Position stärker gewichtet wird. In dem letzten Verfahrensschritt h) wird ein durch den Gewichtungsfaktor aus Schritt f) gewichteter Mittelwert der in Schritt e) normierten nicht-differentiell und differentiell berechneten Positionen des Magneten 2 berechnet, um eine bereinigte Positionsänderung des Magneten 2 zu erhalten. Die Gewichtung ist dabei aufgrund der Berechnungen des Verfahrensschritts g) derart gewählt, dass ein Kompromiss zwischen den Positionen gefunden wird, bei dem die Einflüsse eines nachteiligen Signal-Rausch-Verhältnisses sowie eines starken Fremdfeld möglichst vorteilhaft unterdrückt werden.

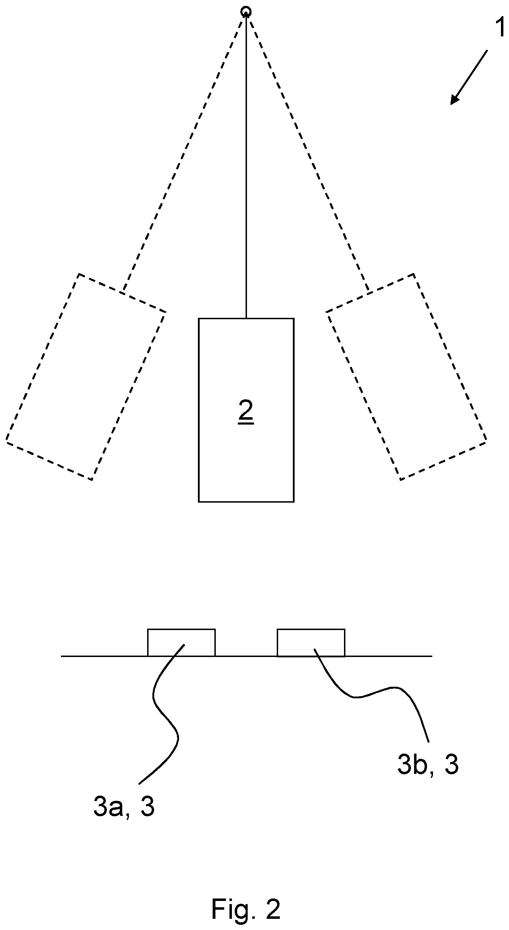

**Fig. 2** zeigt eine Magnet-Sensor-Anordnung 1 in einer bevorzugten Ausführungsform auf die das erfindungsgemäße Verfahren angewendet wird. Die Magnet-Sensor-Anordnung 1 ist dabei gebildet aus einem Magneten 2 und einem Sensorpaar 3, bestehend aus zwei voneinander beabstandeten Sensoren 3a und 3b. Der Magnet ist relativ zu den Sensoren 3a, 3b beweglich gelagert. In diesem Fall ist der Magnet 2 um eine Schwenkachse schwenkbar gelagert, wobei die beiden Sensoren 3a, 3b derart zueinander positioniert sind, dass deren Äquidistanzpunkt unterhalb einer Nullposition des Magneten 2 angeordnet ist. Das Sensorpaar 3 erfasst dabei die vom Magneten 2 ausgehende Magnetflussdichte und ist zur weiteren Verwendung der gemessenen Daten im Verfahren in der Bewegungsrichtung des Magneten 2 angeordnet, sodass also der Magnet 2 in diesem Fall in einer vollwertigen Bewegung über beiden Sensoren positioniert werden kann.

BEZUGSZEICHENLISTE

1    Magnet-Sensor-Anordnung
2    Magnet
3    Sensorpaar
3a    Erster Sensor
3b    Zweiter Sensor

**Patentansprüche**

1.  Verfahren zur Signalverarbeitung aus einer Magnet-Sensor-Anordnung (1), wobei die Magnet-Sensor-Anordnung (1) mindestens ein Sensorpaar (3) und einen dazu bewegbar gelagerten Magneten (2) umfasst, aufweisend die folgenden Schritte:

    a) Messung der Magnetflussdichte je Raumkoordinate je Sensor
    b) Nicht-differentielles Berechnen einer Positionsänderung des Magneten (2) je in Schritt a) gemessener Magnetflussdichte
    c) Berechnen der Differenzen der gemessenen Magnetflussdichten je Raumkoordinate
    d) Differentielles Berechnen einer Positionsänderung des Magneten (2) aus den in Schritt c) berechneten Magnetflussdichten
    e) Normieren der nicht-differentiell und differentiell berechneten Positionsänderung des Magneten (2) auf Basis einer Nullposition des Magneten (2)
    f) Berechnen der Differenzen der differentiell berechneten Positionsänderung des Magneten (2) und den nicht-differentiell berechneten Positionsänderungen des Magneten (2)
    g) Berechnen eines Gewichtungsfaktors aufgrund der in Schritt f) berechneten Differenzen
    h) Berechnen eines durch den Gewichtungsfaktor aus Schritt g) gewichteten Mittelwerts der in Schritt e) normierten nicht-differentiell und differentiell berechneten Positionsänderungen des Magneten (2) um eine bereinigte Positionsänderung zu erhalten.

2.  Verfahren nach Anspruch 1, **dadurch gekennzeichnet, dass** der bewegbare Magnet (2) um mindestens eine Schwenkachse schwenkbar gelagert ist und die Positionsänderung in Form eines Auslenkwinkels gemessen wird.

3.  Verfahren nach Anspruch 2, **dadurch gekennzeichnet, dass** der Auslenkwinkel über eine trigonometrische Funktion aus den gemessenen Magnetflussdichten berechnet wird.

4.  Verfahren nach Anspruch 2 oder 3, **dadurch gekennzeichnet, dass** der differentiell berechnete Auslenkwinkel über eine trigonometrische Funktion aus den Differenzen der gemessenen Magnetflussdichten berechnet wird.

5.  Verfahren nach einem der vorherigen Ansprüche, **dadurch gekennzeichnet, dass** der gewichtete Mittelwert jeweils aus einer der nicht-differentiell berechneten Positionsänderungen und der differentiell berechneten Positionsänderung gebildet wird, wobei die gesamt berechnete Positionsänderung über den Mittelwert der gewichteten Mittelwerte berechnet wird.

**6.** Verfahren nach einem der vorherigen Ansprüche, **dadurch gekennzeichnet, dass** die Normierung nach Schritt e) über einen Mehrpunkt-Abgleich, insbesondere einen 9-Punkt-Abgleich oder 15-Punkt-Abgleich erfolgt.

**7.** Verfahren nach Anspruch 6, **dadurch gekennzeichnet, dass** ein die Messungen beeinflussendes magnetisches Fremdfeld aus der Differenz der beiden unterschiedlich berechneten Positionsänderungen ermittelt wird, wobei diese Positionsänderungen durch den Mehrpunktabgleich korrigiert werden.

**8.** Verfahren nach einem der vorherigen Ansprüche, **dadurch gekennzeichnet, dass** ein die Messungen beeinflussendes magnetisches Fremdfeld aus der Differenz der beiden unterschiedlich berechneten Positionsänderungen ermittelt wird, wobei diese Positionsänderungen durch einen Abgleich mit einer Messung unter Laborbedingungen korrigiert werden.

**9.** Verfahren nach einem der vorherigen Ansprüche, **dadurch gekennzeichnet, dass** bei der Berechnung des Gewichtungsfaktors eine vordefinierbare Konstante $A_{max}$ berücksichtigt wird, welche den Grad der Abweichung zwischen differentieller und nicht-differentiell berechneter Positionsänderung beschreibt, ab dem für die Berechnung der Positionsänderung das Signal ausschließlich aus der differentiell berechneten Positionsänderung nach Schritt d) verwendet wird.

**10.** Verfahren nach einem der vorherigen Ansprüche, **dadurch gekennzeichnet, dass** bei der Berechnung des Gewichtungsfaktors eine vordefinierbare Konstante $O_{diff}$ berücksichtigt wird, durch die vorgegeben werden kann, wie viel Prozent der des differentiellen Signals für die Berechnung der Positionsveränderung zu verwenden ist.

**Claims**

**1.** Method for processing signals from a magnet-sensor arrangement (1), wherein the magnet-sensor arrangement (1) comprises at least one sensor pair (3) and a magnet (2) which is mounted movably thereon, comprising the following steps:

    a) measuring the magnetic flux density per spatial coordinate per sensor
    b) non-differentially calculating a change in position of the magnet (2) for each magnetic flux density measured in step a)
    c) calculating the differences in the measured magnetic flux densities per spatial coordinate
    d) differentially calculating a change in position of the magnet (2) from the magnetic flux densities calculated in step c)
    e) normalizing the non-differentially and differentially calculated change in position of the magnet (2) on the basis of a zero position of the magnet (2)
    f) calculating the differences between the differentially calculated change in position of the magnet (2) and the non-differentially calculated changes in position of the magnet (2)
    g) calculating a weighting factor on the basis of the differences calculated in step f)
    h) calculating a mean value, weighted by the weighting factor from step g), of the non-differentially and differentially calculated changes in position of the magnet (2) normalized in step e) in order to obtain a corrected change in position.

**2.** Method according to claim 1, **characterized in that** the movable magnet (2) is mounted pivotally about at least one pivot axis and the change in position is measured in the form of a deflection angle.

**3.** Method according to claim 2, **characterized in that** the deflection angle is calculated from the measured magnetic flux densities using a trigonometric function.

**4.** Method according to claim 2 or claim 3, **characterized in that** the differentially calculated deflection angle is calculated from the differences in the measured magnetic flux densities using a trigonometric function.

**5.** Method according to any of the preceding claims, **characterized in that** the weighted mean value is formed from one of the non-differentially calculated changes in position and the differentially calculated change in position in each case, the total calculated change in position being calculated using the mean value of the weighted mean values.

**6.** Method according to any of the preceding claims, **characterized in that** the normalization according to step e) is carried out using a multi-point adjustment, in particular a 9-point adjustment or a 15-point adjustment.

7. Method according to claim 6, **characterized in that** an external magnetic field influencing the measurements is determined from the difference between the two differently calculated changes in position, these changes in position being corrected by means of the multi-point adjustment.

8. Method according to any of the preceding claims, **characterized in that** an external magnetic field influencing the measurements is determined from the difference between the two differently calculated changes in position, these changes in position being corrected by means of an adjustment using a measurement under laboratory conditions.

9. Method according to any of the preceding claims, **characterized in that** a predefinable constant $A_{max}$ is taken into account when calculating the weighting factor, which constant describes the degree of deviation between the differential and non-differentially calculated change in position, from which the signal from the differentially calculated change in position according to step d) is used exclusively for calculating the change in position.

10. Method according to any of the preceding claims, **characterized in that** a predefinable constant $O_{diff}$ is taken into account when calculating the weighting factor, which constant can predefine what percentage of the differential signal is to be used for calculating the change in position.

**Revendications**

1. Procédé permettant le traitement de signaux provenant d'un agencement à capteurs magnétiques (1), dans lequel l'agencement à capteurs magnétiques (1) comprend au moins une paire de capteurs (3) et un aimant (2) monté mobile par rapport à ceux-ci, présentant les étapes suivantes :

   a) mesure de la densité de flux magnétique pour chaque coordonnée spatiale pour chaque capteur,
   b) calcul non différentiel d'un changement de position de l'aimant (2) pour chaque densité de flux magnétique mesurée à l'étape a),
   c) calcul des différences des densités de flux magnétique mesurées pour chaque coordonnée spatiale,
   d) calcul différentiel d'un changement de position de l'aimant (2) à partir des densités de flux magnétique calculées à l'étape c),
   e) normalisation du changement de position de l'aimant (2) calculé de manière non différentielle et différentielle sur la base d'une position zéro de l'aimant (2),
   f) calcul des différences entre le changement de position de l'aimant (2) calculé de manière différentielle et les changements de position de l'aimant (2) calculés de manière non différentielle,
   g) calcul d'un facteur de pondération sur la base des différences calculées à l'étape f),
   h) calcul d'une valeur moyenne pondérée par le facteur de pondération de l'étape g) des changements de position de l'aimant (2) calculés de manière non différentielle et différentielle normalisés à l'étape e) afin d'obtenir un changement de position ajusté.

2. Procédé selon la revendication 1, **caractérisé en ce que** l'aimant (2) mobile est monté pivotant autour d'au moins un axe de pivotement et le changement de position est mesuré sous forme d'angle de déviation.

3. Procédé selon la revendication 2, **caractérisé en ce que** l'angle de déviation est calculé par l'intermédiaire d'une fonction trigonométrique à partir des densités de flux magnétique mesurées.

4. Procédé selon la revendication 2 ou 3, **caractérisé en ce que** l'angle de déviation calculé de manière différentielle est calculé par l'intermédiaire d'une fonction trigonométrique à partir des différences des densités de flux magnétique mesurées.

5. Procédé selon l'une des revendications précédentes, **caractérisé en ce que** la valeur moyenne pondérée est formée respectivement à partir de l'un des changements de position calculés de manière non différentielle et du changement de position calculé de manière différentielle, dans lequel le changement de position total calculé est calculé par l'intermédiaire de la valeur moyenne des valeurs moyennes pondérées.

6. Procédé selon l'une des revendications précédentes,

**caractérisé en ce que** la normalisation selon l'étape e) est effectuée par l'intermédiaire d'un alignement multipoints, en particulier d'un alignement à 9 points ou d'un alignement à 15 points.

7. Procédé selon la revendication 6, **caractérisé en ce qu'**un champ magnétique étranger influençant les mesures est déterminé à partir de la différence entre les deux changements de position calculés différemment, dans lequel lesdits changements de position sont corrigés par l'alignement multipoints.

8. Procédé selon l'une des revendications précédentes, **caractérisé en ce qu'**un champ magnétique étranger influençant les mesures est déterminé à partir de la différence entre les deux changements de position calculés différemment, dans lequel lesdits changements de position sont corrigés par un alignement avec une mesure dans des conditions de laboratoire.

9. Procédé selon l'une des revendications précédentes, **caractérisé en ce que**, lors du calcul du facteur de pondération, une constante prédéfinissable $A_{max}$ est prise en compte, laquelle décrit le degré d'écart entre le changement de position calculé de manière différentielle et le changement de position calculé de manière non différentielle à partir duquel le signal provenant exclusivement du changement de position calculé de manière différentielle selon l'étape d) est utilisé pour le calcul du changement de position.

10. Procédé selon l'une des revendications précédentes, **caractérisé en ce que** le calcul du facteur de pondération prend en compte une constante prédéfinissable $O_{diff}$, laquelle permet de prédéfinir quel pourcentage du signal différentiel doit être utilisé pour le calcul de la variation de position.

Fig. 1

1

<u>2</u>

3b, 3

3a, 3

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1464918 B1

- DE 102018129487 A1